# EUROPEAN PATENT APPLICATION

(11) **EP 4 550 594 A1**
(43) Date of publication of application: **07.05.2025**
(21) Application number: 23831568.3
(22) Date of filing: 29.06.2023
(51) Int. Cl.: H01S 5/347

(54) **ZINC OXIDE-BASED QUANTUM CASCADE LASER ELEMENT**

(30) Priority: 01.07.2022 JP 2022106750
(71) Applicant: RIKEN, Wako-shi, Saitama 351-0198 (JP)
(72) Inventor: WANG, Li, Wako-shi Saitama 351-0198 (JP); HIRAYAMA, Hideki, Wako-shi Saitama 351-0198 (JP)
(74) Representative: Huebner, Stefan Rolf
(86) International application number: PCT/JP2023/024143
(87) International publication number: WO 2024/005129

(57) **Abstract**

In order to provide a THz-QCL element which takes advantage of the characteristics of a ZnO-based semiconductor material, the present disclosure provides a quantum cascade laser element which has a semiconductor superlattice structure (a QCL structure 100), wherein the semiconductor superlattice structure has a plurality of unit structures 10U that are stacked repeatedly. Each unit structures 10U comprises three well layers 10W1 - 10W3 having a composition of ZnO or ZnMgO, and barrier layers 10B1 - 10B3 having a composition of ZnMgO or MgO that separates each well layer from each other and have a higher ratio of MgO than the left and right wells.

## Description

### Technical Field

The present disclosure relates to a quantum cascade laser (QCL) element. More specifically, the present disclosure relates to a QCL element that uses a zinc oxide semiconductor material.

### Background Art

Quantum cascade lasers (QCLs) have attracted increasing attention. In general, QCL elements have a semiconductor superlattice structure that includes a repetition of unit structures, and the carriers that are responsible for electrical conduction within the structure are electrons. In addition to the bias electric field caused by external voltage, the electrons are also affected by the potential of each layer that forms the unit structure. The potential acting on the electrons generally has multiple wells and barriers in each unit structure. The wells and barriers of the potential for electrons form a bumpy profile determined by the conduction band edge of the material of each layer that forms the unit structure and the conduction band offset according to the position of the thickness, and when an external voltage is applied to operate the QCL element, the potential as a whole tilts due to the bias electric field. The electrons that act as the carriers are transported through the subbands, or quantum levels, that are formed in the tilted and uneven potential, and they repeat intersubband transitions (ISBT). When stimulated emission occurs due to interaction with the electromagnetic wave field in each transition, lasing operation can be achieved. For this reason, the semiconductor superlattice structure serves as the active region for light emission. The name "cascade" is used because the electrons are transported while losing their energy through subband transitions. In a QCL element, a wavelength can be selected independently of the energy band gap of the material to achieve lasing operation. The lasing wavelength or frequency can be changed by the material and design of the semiconductor superlattice structure. For this reason, QCL elements have attracted attention as unipolar semiconductor lasers that can serve as coherent light sources in wavelength ranges (frequency ranges) that have not been achieved by solid-state light sources. To date, QCLs in the mid-infrared and far-infrared ranges have been commercialized.

Quantum cascade lasers for the THz range (hereafter referred to as "THz-QCL") have been experimentally realized, and most of the successes have been achieved using QCLs based on GaAs/AlGaAs quantum well systems ("GaAs-based THz-QCL"). However, GaAs-based THz-QCLs generally suffer from the following problems. First, they require cooling because they must operate at low temperatures. Second, their lasing frequency is limited to 5.4 THz or less. These two problems can be attributed to the small longitudinal optical (LO) phonon energy of GaAs, which is 36 meV. However, the former problem of low operating temperature can be addressed to some extent by reducing the non-radiative channel through phonon emission due to thermally excited electrons at high temperatures. In contrast, the latter is attributable to the reststrahlen bands (30 to 50 meV) of the LO phonons in GaAs, so it is difficult to achieve lasing frequencies above 5.4 THz with GaAs-based materials, which have low LO phonon energy. The lasing frequency range demonstrated so far for GaAs-based THz-QCLs is between 1.1 THz and 5.4 THz, within which the highest operating temperature is obtained in a narrow range between 3 THz and 4 THz. In THz-QCLs, lasing has not yet been achieved in the frequency range between 6 and 12 THz, and this range is referred to as a THz gap.

With the aim of demonstrating lasing in the THz gap and achieving high-temperature operation, QCLs with semiconductor materials having large LO phonon energy, in particular, QCLs with GaN/AlGaN semiconductor materials ("GaN-based THz-QCLs") have been developed (e.g., Patent Document 1).

### Citation List

### Patent Document(s)

Patent Document 1: JP 2016-042572 (Patent No. 6627309)

### Non-Patent Document(s)

Non-Patent Document 1: Enrico Bellotti, Kristina Driscoll, Theodore D. Moustakas, and Roberto Paiella, "Monte Carlo simulation of terahertz quantum cascade laser structures based on wide-bandgap semiconductors", Journal of Applied Physics 105, 113103 (2009); DOI:10.1063/1.3137203
Non-Patent Document 2: V.P. Sirkeli, H.L. Hartnagel, "ZnO-based terahertz quantum cascade lasers", Opto-Electronics Review, Volume 27, Issue 2, June 2019, Pages 119-122, DOI:10.1016/j.opelre.2019.04.002

### Summary of Disclosure

### Technical Problem

In addition to GaN/AlGaN semiconductor materials, much interest has been directed towards THz-QCLs with semiconductor materials with a composition of zinc oxide (ZnO) or a mixture of ZnO and MgO (ZnMgO) materials (referred to as "ZnO-based semiconductors"), which are herein referred to as "ZnO-based THz-QCL". This is because ZnO has a LO phonon energy of 72 meV, which is about twice as large as that of GaAs, and so it is an attractive material for filling the THz gap corresponding to reststrahlen bands for other materials. In particular, the progress in epitaxial technology for ZnO-based materials for non-polar crystal orientations has enhanced the feasibility in actually fabricating ZnO-based THz-QCLs, which require the fabrication of superlattice structures. For example, Non-patent Documents 1 and 2 disclose ZnO-based THz-QCLs.

However, the design of conventional ZnO-based THz-QCLs has been done by simply applying the design methods that have been used for GaAs-based THz-QCLs (Non-patent Documents 1 and 2). In ZnO-based THz-QCLs, the intrinsic advantages of ZnO-based semiconductors have not been fully leveraged, and there is still room for improvement in their design.

The present disclosure is intended to solve at least some of the problems described above. The present disclosure is based on the idea of a new operating mechanism for a QCL that can fully exploit the performance of ZnO-based semiconductor materials in a ZnO-based THz-QCL, in which a specific structure for a THz-QCL that operates at high temperatures and in frequency regions where lasing has not been achieved is proposed.

### Solution to Problem

The present inventors have made full use of the NEGF (non-equilibrium Green's function) method, a calculation method capable of highly accurate performance prediction, to explore the operating mechanism suitable for ZnO-based semiconductor materials and a design that utilizes it, and as a result, discovered a specific structure for ZnO-based QCLs based on a new idea that could exploit the properties of ZnO-based semiconductor materials.

In other words, provided in this disclosure is a quantum cascade laser element having a semiconductor superlattice structure sandwiched between a pair of conductive portions, wherein the semiconductor superlattice structure has a plurality of unit structures that are repeatedly stacked, wherein each unit structure consists of: three well layers each having a composition of ZnO or ZnMgO; and barrier layers each having a composition of ZnMgO or MgO, the barrier layers separating the well layers from one another and having a higher content of MgO than the well layers adjacent thereto on both sides, and wherein the semiconductor superlattice structure serves as an active region for emitting electromagnetic waves of a wavelength upon application of an external voltage through the pair of conductive portions for operation.

In this application, electromagnetic waves in the THz region refer to electromagnetic waves in the frequency range of approximately 0.1 THz to 30 THz, or in the wavelength range of approximately 10 µm to 3 mm. Furthermore, in the description of this application, the element structure and functions may be explained using technical terms adopted or borrowed from the fields of electronic devices and physics that deal with visible light and infrared rays. For this reason, even when explaining electromagnetic waves in wavelength ranges or frequency ranges that cannot be considered visible light, the terms "laser" and "light emission" may be used to describe quantum cascade laser elements as well as the phenomenon of stimulated emission, and terms such as "light", "optical-" and "photo-" may be used. Optical confinement and refraction are also examples of the above. The wavelength is determined according to the convention of referring to the value in a vacuum, even where it is in a material. Also, the fact that a level is formed in a well layer does not mean that the probability of finding an electron determined by the wave function of that level is 100% within the area of that well layer. In explanations of semiconductor engineering fields such as quantum wells and semiconductor superlattices, terms from the field of quantum mechanics such as ground state and first excited state are also used as appropriate. For example, the discrete energy states of the ground state, first excited state, and second excited state of electrons in a quantum well refer to the quantum mechanical levels of electrons that are bound and generally discrete in a one-dimensional quantum well, and are also referred to as subbands in QCL elements. In addition, the carriers responsible for electrical conduction and optical transitions in the QCL element of this application are electrons.

### Advantageous Effects of Disclosure

In any of the embodiments of the present disclosure, a practical ZnO-based THz-QCL element is provided that can take advantage of the characteristics of ZnO-based semiconductors.

### Brief Description of Drawings

FIGS. 1A-C are a perspective view (FIG. 1A), an enlarged cross-sectional view (FIG. 1B), and a further enlarged cross-sectional view (FIG. 1C) showing an overview of the structure of the ZnO-based THz-QCL element in embodiments of the present invention.
FIGS. 2A-D show examples of designs based on conventional ideas for ZnO-based THz-QCLs (FIGS. 2A and 2B) and designs for embodiments of the present disclosure (FIGS. 2C and 2D).
FIGS. 3A-E are graphs showing the results of numerical simulations to estimate the optical gain at each frequency in the active region of a ZnO-based THz-QCL using the design method of an embodiment of the present disclosure.
FIG. 4 is a map showing the peak intensity of the optical gain by density at each position as a function of the lasing frequency and the corresponding maximum operating temperature in the ZnO-based THz-QCL of an embodiment of the present disclosure.
FIGS. 5A-E are maps showing the electron density distributions at room temperature (300 K) for different lasing frequencies in a design example of an embodiment of the present disclosure, with respect to the thickness direction position and energy.
FIGS. 6A-B are maps showing variations in peak gain as a function of detuning energy and anti-crossing energy between the lower lasing level and the injection level for lasing frequencies of 3.5 THz and 8.5 THz in a ZnO-based THz-QCL, an embodiment of the present disclosure.
FIGS. 7A-B are a schematic diagram and a flowchart for illustrating the design strategy of an embodiment of the present disclosure.
FIG. 8A-B shows the calculated emission spectra (FIG. 8A) and the peak gains at each temperature for these ZnO-based THz-QCLs and GaAs-based semiconductor materials operating at 4 THz (FIG. 8B).
FIGS. 9A-B are graphs showing the dependencies of current density on electric field for ZnO-based THz-QCLs in an embodiment of the present disclosure, with lasing frequency design values of 3 THz and 8 THz, respectively.

### Description of Embodiments

### 1. Embodiment

The embodiment of the QCL element of the present disclosure is described below with reference to the drawings. Common reference numerals are given to common parts or elements, unless otherwise noted in the description. In addition, each element in each embodiment should not be understood as not being drawn to scale.

### 1-1. Operating Mechanism and Design Guidelines Suitable for the Physical Properties of ZnO-based Semiconductors

Semiconductor materials with a composition of zinc oxide (ZnO) or a mixture (ZnMgO) of ZnO and magnesium oxide (MgO) (referred to as "ZnO-based semiconductors") differ from GaAs-based semiconductor materials in the following three respects from the perspective of THz-QCL design.
(1) In ZnO-based semiconductors, the intensity of the Froehlich coupling, or the coupling between electrons and LO phonons, is 21 times stronger than in GaAs-based semiconductor materials. This is because the ratio of the low-frequency and high-frequency dielectric constants (εᵣε∞ in the THz band) in ZnO is εᵣ = 8.9, ε_{∞} = 3.7, which is much smaller than the values for GaAs (εᵣ = 12.93, ε_{∞} = 10.89).
(2) In ZnO-based semiconductor materials, the increase in interface roughness due to interdiffusion is a serious problem.
(3) In ZnO-based semiconductor materials, the effective mass of the electrons that act as carriers in THz-QCL is large.
Table 1 shows the physical properties of GaAs- and ZnO-based semiconductor materials, along with those of GaN-based materials.

**[Table 1]**

| | GaAs | GaN | ZnO |
|---|---|---|---|
| Effective Mass of Electron, m*/m₀ | 0.06 | 0.2 | 0.24 |
| Band Gap Energy (eV), E_{g} | 1.42 | 3.39 | 3.37 |
| Conduction Band Offset (meV), Δ E_{c} | 200 (GaAs/Al_{0.2}Ga_{0.8}As) | 270 c-plane GaN/Al_{0.15}GaN | 420 c-plane ZnO/Zn_{0.8}MgO |
| Refractive Index | 3.62 (3THz, >500 *µ*m) | 3.2 (8THz, 500 *µ*m) | 3.16 (7THz, 500 *µ*m) |
| Relative Permittivity (Top: for low frequency, Bottom: for high frequency) | 12.93 | 10.32 | 8.9 |
| | 10.89 | 5.41 | 3.7 |
| LO Phonon Energy (meV) | 36 | 91 | 72 |

Due to the difference stated in (1) above, ZnO-based semiconductor materials are generally not suitable for THz-QCLs for low frequencies of less than 6 THz. However, even for higher frequencies of 6 THz or more, meticulous design is required. In the ZnO-based THz-QCL of the embodiment of the present disclosure, electron-electron scattering is employed as the electron transport mechanism for depopulation of electrons from the lower lasing level, instead of the conventional method that combines resonant tunneling and electron-LO phonon scattering in the layer due to resonant phonons. As a result, in the present embodiment of the ZnO-based THz-QCL, the increase in the emission line width is suppressed while maintaining a sufficiently high electron depopulation efficiency from the lower lasing level. As a specific method for enhancing electron-electron scattering-induced electron depopulation, in the present embodiment of the ZnO-based THz-QCL, the balance between the detuned energy and the anti-crossing energy is carefully set across the lower lasing level and the injection level in the region where electron scattering occurs (the region between the first barrier layer, as will be described later). Furthermore, even if the design based on the conventional idea that has been adopted for GaAs-based THz-QCLs, i.e., the "RP method" design that uses electron-LO phonon scattering by resonant phonons in a three-well structure, is applied to ZnO-based semiconductor materials, the level broadening will occur, the lasing linewidth will increase, and the gain will become very small. This is related to the strength of the Fröhlich coupling in the ZnO semiconductor.

In addition, the present embodiment of the ZnO-based THz-QCL does not rely on resonance tunneling for electron transport, including injection, in accordance with the performance described in (2) above. This is because the ZnO material is prone to serious increases in interface roughness due to interdiffusion, which makes it difficult to precisely control the layers when relying solely on resonance tunneling. In addition, in the present embodiment of the ZnO-based THz-QCL, diagonal indirect injection is used instead of typical resonant tunneling injection in order to enhance the injection of electrons with the aim of maximizing the population inversion.

The large effective mass of electrons in the ZnO material described in (3) above generally weakens the coupling between subbands belonging to two different wells. In this case, it is necessary to increase the doping amount in the THz-QCL element. However, this also increases the Coulomb interaction of electrons, which results in an increase in linewidth. To deal with this, it is also necessary to carefully set the balance between the detuned energy and the anti-crossing energy.

In order to design the ZnO-based THz-QCL of the present embodiment as described above, it is necessary to accurately reflect actual electron transport phenomena such as Fröhlich coupling and electron-electron scattering. Therefore, an advanced numerical simulation model based on the non-equilibrium Green's function (NEGF) method is adopted as a design tool for ZnO-based THz-QCLs in the present embodiment. First, in the present embodiment, the gain value is estimated by incorporating the above-mentioned broadening of the level width in the ZnO-based THz-QCL, and then a strategy to suppress the effect of the broadening of the level width is proposed. In this embodiment, a ZnO-based THz-QCL is proposed considering the effect of the broadening of the level width due to strong Fröhlich coupling.

### 1-2. Element Structure

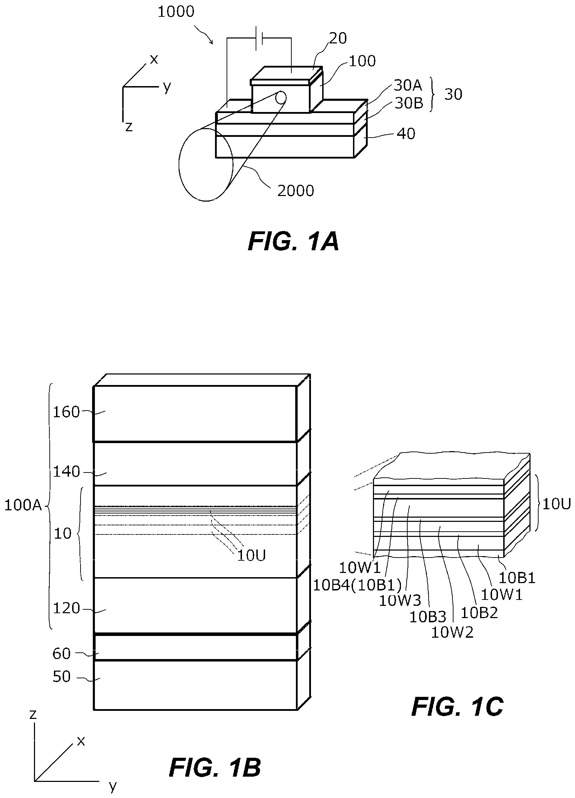

FIGS. 1A-C are a perspective view (FIG. 1A), an enlarged cross-sectional view (FIG. 1B), and a further enlarged cross-sectional view (FIG. 1C) showing an overview of the structure of the ZnO-based THz-QCL element in the present embodiment. A typical ZnO-based THz-QCL element 1000 (FIG. 1A) of the present embodiment generally comprises a pair of electrodes 20 and 30 (a pair of conductive portions) and a QCL structure 100, which is a semiconductor superlattice structure sandwiched between the electrodes. The electrodes 20 and 30 are used to receive the voltage and electric current from outside, where the voltage for forming an electric field for the QCL structure 100 and the current for emitting electromagnetic waves, i.e., for emitting light. In addition, electrodes 20 and 30 are typically formed of metal, and when electromagnetic waves in the THz region act on them, surface plasmons are induced, and as a result, electrodes 20 and 30 also exhibit the effect of light confinement due to the cavity structure. This structure is also called a double metal waveguide (DMW) structure. It should be noted that electrodes 20 and 30 do not necessarily have to be metallic. For example, one of them can be a high-concentration n-doped layer, so that one side is a metallic layer and the other side is a highly conductive semiconductor layer (single-sided metallic waveguide structure). The QCL structure 100 has an active region 10. The THz-QCL element 1000 operates by allowing electrons to go through the active region 10 over the thickness direction, forming a repetitive structure of electron potentials when the above voltage is applied. During this passage, the electrons transition among subbands, or levels, and release electromagnetic waves 2000 in the THz region. The THz-QCL element 1000 in FIG. 1 is fabricated by forming a metal layer 30B of the electrode 30 on the receptor substrate 40 (hereinafter referred to as "receptor 40") and then bonding it to the metal layer 30A formed on the QCL structure 100. In addition to these, in the THz-QCL element 1000 of FIG. 1, suitable layers for operation and element fabrication, such as the highly doped layers 120 and 140, the δ-doped layer 160, and the etching stopper layer 60, may be employed as needed.

The active region 10 (FIG. 1B) has a plurality of unit structures 10U of a certain thickness, each of which includes a plurality of alternatingly stacked well layers 10W and barrier layers 10B, and each unit structure 10U is stacked repeatedly in the thickness direction. In the semiconductor superlattice structure 100A shown in FIG. 1B, the active region 10 is generally composed of unit structures 10U of the same structure stacked repeatedly for 10 to 200 cycles. FIG. 1C shows an enlarged view of the structure of one unit (one cycle) of each unit structure 10U. Each unit structure 10U comprises three well layers 10W and three barrier layers 10B, and each well layer 10W is separated from the others by each barrier layer 10B. The individual well layers 10W are distinguished as the first well layer 10W1, the second well layer 10W2, and the third well layer 10W3, in the order from the substrate 50 side. The first well layer 10W1, second well layer 10W2, and third well layer 10W3 are also referred to as the injection well layer, upper emission well layer, and lower emission well layer, respectively. Individual barrier layers 10B are also distinguished as necessary, and are called the first barrier layer 10B1, second barrier layer 10B2, and third barrier layer 10B3, in the order from the substrate 50 side. The first barrier layer 10B1, second barrier layer 10B2, and third barrier layer 10B3 are also referred to as the depopulation barrier layer, injection barrier layer, and emission barrier layer, respectively. The well layer 10W1 is arranged adjacent to the barrier layer 10B1, the barrier layer 10B2 is arranged adjacent to the well layer 10W1, and the layers are stacked in the same way. The barrier layer 10B4 corresponds to the barrier layer 10B1 of the next unit structure 10U. In the present embodiment, the range over the thickness direction of the first barrier layer 10B1 of one unit structure 10U and the first barrier layer 10B1 (barrier layer 10B4) of the next unit structure 10U is explained as one cycle of the unit structure 10U. However, which range is selected as the unit structure 10U is a matter of convenience for the purpose of explanation.

Each unit structure 10U comprises at least three well layers 10W of the composition Zn₁₋ₓMgₓO, which are separated from each other by barrier layers 10B of the composition Zn_{1-y}Mg_{y}O, where 0≤x<y≤1. This semiconductor superlattice structure 100A serves as an active region that emits electromagnetic waves of a certain wavelength in response to the external voltage applied for operation through a pair of conductive portions such as electrodes 20 and 30.

The substrate 50 can be made of any material that can be used for the epitaxial growth necessary for the fabrication of ZnO-based THz-QCL. The substrate 50 can be made of a single layer wafer or a wafer with an appropriate buffer layer. In order to fabricate ZnO-based THz-QCLs with unpolarized and polarized directions, a sapphire substrate is typically used as the substrate 50. Epitaxial growth of ZnO-based semiconductors can be carried out using any method, such as molecular beam epitaxy (MBE). In order to make electrons into carriers, gallium (Ga) is added as a dopant to make the conduction type n-type in any of the well layers of the unit structure 10U.

### 1-3. Transport Mechanism of Electrons

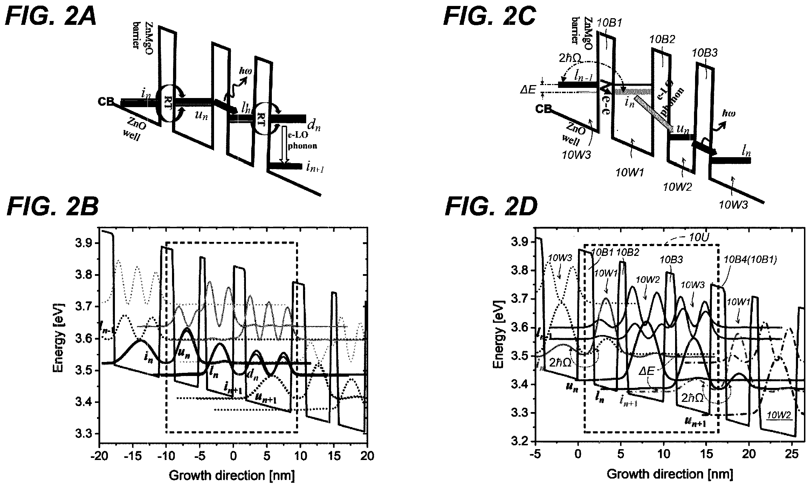

FIGS. 2A-D show examples of designs for ZnO-based THz-QCLs, contrasting those based on conventional ideas (FIGS. 2A and B) with those based on the present embodiment (FIGS. 2C and 2D). The symbols indicating the various parts of the potential profile are the same as those for the corresponding layers. Both the design example based on the conventional idea and the design example of the present embodiment are non-polar ZnO-based THz-QCLs with three quantum wells in a unit structure that uses ZnO for the well layer and Zn_{0.8}Mg_{0.2}O for the barrier layer. The potential for electrons is low in the well layer made of ZnO and high in the barrier made of Zn_{0.8}Mg_{0.2}O, as shown in the conduction band edge profiles CB in FIGS. 2A and 2C. The three quantum wells in the unit structure show an overall downward slope in response to the external electric field that is applied as a bias. The unit structure is shown as a chain line in FIGS. 2B and 2D. The electrons flow from left to right on the paper as a whole. Each level is sometimes distinguished by the suffix n, etc., which increases toward the right, and the unit structure to which it belongs.

The term "conventional method" refers to the application of the conventional ideas developed for GaAs-based THz-QCLs to ZnO-based THz-QCLs. In the design examples of ZnO-based THz-QCLs using conventional methods (FIGS. 2A and 2B), there are four main levels that are involved in electron transport and the resulting luminescence operation. If we show these levels in order from upstream to downstream, in such a way that the center of gravity of the probability of finding electrons lies from upstream to downstream, they are the injection level iₙ, the upper lasing level uₙ, the lower lasing level lₙ, and the depopulation level dₙ. In conventional methods, the physical phenomena responsible for electron transport between each level are as follows.
~ From the injection level iₙ to the upper lasing level uₙ: resonant tunneling,
~ From upper lasing level uₙ to lower lasing level lₙ: optical transition (transition among subbands emitting THz waves),
~ From lower lasing level lₙ to depopulation level dₙ: resonant tunneling, and
~ From depopulation level dₙ to injection level iₙ₊₁: vertical transition due to electron-LO phonon scattering.

This combination of electron transport mechanisms has been adopted for GaAs-based THz-QCLs, and here we apply it directly to ZnO-based THz-QCLs. Specifically, as shown in FIGS. 2A and 2B, the mechanism of injection of electrons from the injection level iₙ to the upper lasing level uₙ is resonant tunneling (RT). Resonant tunneling is a phenomenon related to the energy levels that are discretized in the well. In resonant tunneling, electrons tunnel resonantly across a barrier. In this case, if the wave functions of electrons in each of the left and right wells have energies close to discrete energy levels such as the ground state, first excited state, and second excited state, they will have anti-nodes of oscillation in the wells and the probability of finding them there will be high. If the conditions for the depth and bias electric field are such that the energy levels are simultaneously the discretized levels in both wells, the wave function will have anti-nodes of oscillation in both wells, and the probability of finding the wave function in both wells will be high. There is more than one wave function that can have such an energy value, and even if both wells are separated by a barrier of finite thickness and height, electrons tunnel between the wave functions. The structure and operating conditions of the lower lasing level lₙ and the depopulation level dₙ are set so that this relationship is satisfied.

Here, the depopulation of electrons from the lower lasing level lₙ involves two transport mechanisms: resonant tunneling to the depopulation level dₙ and a vertical transition accompanied by the emission of one quantum of LO phonon to the injection level iₙ₊₁. In this case, the lower lasing level lₙ is delocalized. This is because the lower lasing level lₙ comes to have an energy value that is almost the same as the energy of the depopulation level dₙ due to resonant tunneling, and it spreads in the same way as the depopulation level dₙ. Then, the downstream injection level iₙ₊₁, which receives electrons from the depopulation level dₙ via LO phonon emission, also strongly couples with the lower lasing level lₙ, which has the same energy as the depopulation level dₙ. The coupling between the lower lasing level *l*ₙ and the downstream injection level iₙ₊₁, where the LO phonon is involved, causes a serious linewidth broadening of the lower lasing level *l*ₙ. If the linewidth broadening is represented by Γ, the gain of the optical transition is proportional to 1/Γ, so lasing operation cannot be expected using conventional methods. The reason why this design method is not suitable for ZnO-based semiconductor materials, despite being effective for GaAs-based semiconductor materials, is related to the difference in the interaction between electrons and LO phonons, or the Fröhlich coupling. In ZnO-based semiconductor materials, where the Fröhlich coupling is extremely strong, at 21 times that of GaAs-based semiconductor materials, the LO phonons strongly couple with the electrons, causing a significant increase in line width and a serious decrease in gain.

In contrast, in the design examples of the present embodiment (FIGS. 2C and 2D), three levels are mainly involved in the transport of electrons and the resulting light emission. In order to achieve population inversion, it is necessary to design a structure that increases the efficiency of electron injection into the upper lasing level uₙ and at the same time improves the rate of depopulating electrons from the lower lasing level lₙ. In the present embodiment of the design of a ZnO-based THz-QCL (FIGS. 2C and 2D), three levels are involved in electron transport per unit structure 10U of the THz-QCL, namely the injection level iₙ, the upper lasing level uₙ, and the lower lasing level lₙ. The phenomena for electron transport adopted in the design example of the present embodiment are as follows.
~ From the lower lasing level lₙ₋₁ to the injection level iₙ: electron-electron scattering (e-e),
~ From the injection level iₙ to the upper lasing level uₙ: diagonal transition due to electron-LO phonon scattering, and
~ From upper lasing level ᵤₙ to lower lasing level ₗₙ: Optical transition (subband transition of THz wave emission).

More specifically, electron-electron scattering is involved in the transition from the lower lasing level lₙ₋₁ to the injection level iₙ. For this reason, in the design of the present embodiment, each layer is designed so that the lower lasing level lₙ₋₁ and the injection level iₙ are coupled to each other while having a non-zero energy difference (detuned energy) under the condition where an external electric field (bias electric field) for operation is applied. This adjustment is described later (Section 1-6). The supplying of electrons (injection operation) from the injection level iₙ to the upper lasing level uₙ is caused by the diagonal transition of electron-LO phonon scattering, which emits one quantum of LO phonon. Looking at the relationship between each well layer 10W and each level in this case, under the external voltage, the injection level iₙ is the ground state for the first well layer 10W1, the upper lasing level uₙ is the ground state for the second well layer 10W2, and the lower lasing level lₙ is the ground state for the third well layer 10W3. This relationship can also be expressed as follows: under the external voltage, the injection level iₙ has one peak of probability of finding electrons in the first well layer 10W1, the upper lasing level uₙ has one peak of probability of finding electrons in the second well layer 10W2, and the lower lasing level lₙ has one peak of probability of finding electrons in the third well layer 10W3.

Comparison of the design of the present embodiment (FIGS. 2C and 2D) with the design based on the conventional concept (FIGS. 2A and 2B) reveals that in the ZnO-based THz-QCL of the present embodiment, the lower lasing level lₙ₋₁ and the injection level iₙ are detuned so that they have an appropriate energy difference, i.e., detuning energy ΔE. As a result of the detuning, the probabilities of finding the lower lasing level lₙ₋₁ and the injection level iₙ in the third well layer 10W3 and the first well layer 10W1 are different. This difference is clearly seen in the difference in the amplitude of each level in FIG. 2D. In contrast, in designs based on conventional approaches, the lower lasing level lₙ and the depopulation level dₙ are made to have the same energy value as much as possible, and the injection level iₙ and the upper lasing level uₙ are made to have the same energy value as much as possible, so that electrons are transported resonantly. In other words, this example of a ZnO-based THz-QCL design in the present embodiment should be contrasted in that it does not use resonant tunneling, with the design examples based on the conventional idea. In addition, although electron-LO phonon scattering, in which one quantum of LO phonons is emitted, is involved, in the design example based on the conventional approach, the electron transition (vertical transition) occurs within the same well, whereas in the present embodiment, the upper lasing level uₙ belongs to a different well from the injection level iₙ, so the transition is diagonal, thus they differ. The difference between a diagonal transition and a vertical transition is whether the electron moves spatially before and after the transition or not. Transitions in which the spatial position with a high probability of finding electrons, such as the transition from the depopulation level dₙ to the iₙ₊₁ injection level in FIG. 2A, does not move substantially during the transition are called vertical transitions. In contrast, the transitions used in the design example of the present embodiment involve a displacement of the position with a high probability of finding electrons with a spatial movement of electrons. In fact, the transition from the injection level iₙ to the upper lasing level uₙ shown in FIGS. 2C and 2D involves a displacement across the barrier layer 10B in the left-right direction on the paper plane (i.e., the z-direction in FIG. 1B, or the thickness direction of the multilayer). In this way, in the present embodiment, the LO phonon is used for indirect injection via diagonal transition (diagonal indirect injection), whereas in the design example based on the conventional approach, the LO phonon is used for vertical transition rather than injection. It should be noted that the involvement of LO phonons in injection is also referred to as indirect injection.

In both the conventional approach and the present embodiment, the material is a ZnO-based semiconductor, and there is no difference in the fact that the strength of Fröhlich coupling is large. In addition, electron-LO phonon scattering is involved in electron transport in both cases. Furthermore, the number of levels involved in the present embodiment is rather smaller than that in the conventional approach. Nevertheless, the inventor believes that the reason why the involvement of LO phonons does not lead to an increase in line width in the present embodiment design is as follows. When looking from the injection level iₙ, LO phonon scattering is involved in the electron transport to the upper lasing level u downstream. However, the electron transition is a diagonal transition, and it is a transition from the second well layer 10W2 to the third well layer 10W3 across the third barrier layer 10B3. Therefore, unlike the case of the LO phonon acting on the two levels that coexist in the same well in the conventional design, the magnitude of the strength of the Fröhlich coupling is not directly linked to the formation of a state that combines electrons and lattice vibrations, and it also has little effect on the energy line width through the upper lasing level u. Furthermore, looking at the relationship with the lower lasing level lₙ₋₁ upstream seen from the injection level iₙ, as a result of detuning, the probabilities of finding an electron in the injection level iₙ and the lower lasing level lₙ₋₁ right before it are distributed as shown in FIG. 2D, with the injection level iₙ having a significant value in the first well layer 10W1 and the lower lasing level lₙ₋₁ having a significant value in the third well layer 10W3. For this reason, it is unlikely that a situation will arise as in conventional designs, where the depopulation level dₙ and the lower lasing level lₙ form indistinguishable levels (FIG. 2B), and electrons in both the depopulation level dₙ and the lower lasing level lₙ are scattered by LO phonons. Even if the injection level iₙ is affected by LO phonons, this is unlikely to affect the energy line width through the lower lasing level lₙ₋₁. This is the reason why the use of LO phonon scattering in the design of the ZnO-based THz-QCL in the present embodiment does not lead to an increase in the line width of the optical transition, i.e., a decrease in optical gain.

### 1-4. Numerical Simulation

In the present embodiment, a design example of a ZnO-based THz-QCL is provided, and the performance of this design example is predicted by numerical simulation. The detailed conditions for one of the design examples are as shown in Table 2. The simulation is performed on the characteristics of electron transport in the QCL structure 100 to obtain the optical characteristics.

**[Table 2]**

| Items | Adopted for Computation |
|---|---|
| The Number of Unit Structure 10U in a QCL Structure 10 | 470 |
| Materials for 1st - 3rd Barrier Layers B1-B3 | Zn_{0.8}Mg_{0.2}O |
| Thicknesses of 1st - 3rd Barrier Layers B1-B3 | 2, 1.1, 1.35(nm) |
| Dope layer | 5 × 10¹⁷/cm³ |
| Materials for 1st - 3rd Well Layers W1-W3 | ZnO |
| Thicknesses of 1st - 3rd Well Layers W1-W3 | 2.3, 4.65, 4.35(nm) |
| External Electric Field | 65V/cm~70V/cm |
| Lasing Frequency | 1.8THz-15THz |
| Operating Temperature | 10K~300K |

In addition to these conditions, several assumptions are made in the numerical simulation using the NEGF method in the present embodiment. It is assumed that the condition in which the dipole matrix element between the upper lasing level and the lower lasing level involved in the optical transition is 1 nm. Since electron-electron scattering is involved in the depopulation of electrons from the lower lasing level lₙ to the injection level iₙ₊₁ in this disclosure, a relatively high doping level is adopted, with a sheet doping value, averaged over the period, of 1.5×10¹¹ cm⁻².

### 1-5. Simulation Results (Frequency Range and Optical Gain)

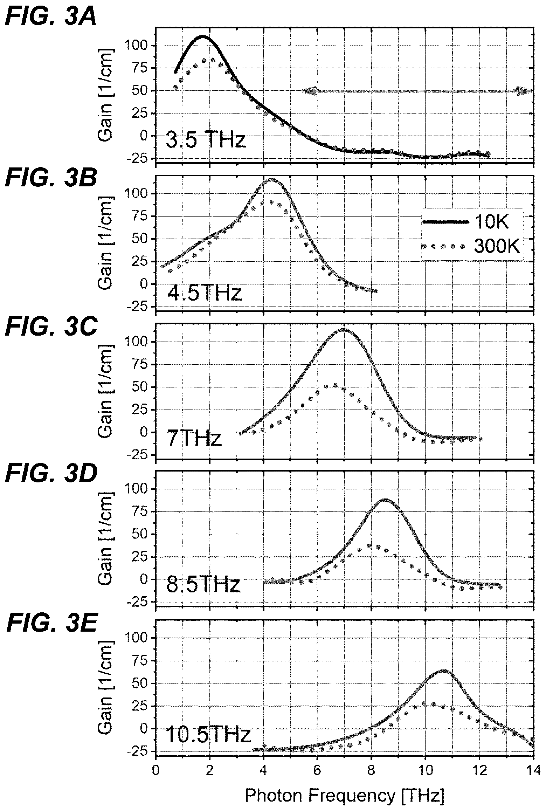

FIGS. 3A-E are graphs showing the results of numerical simulations to determine the optical gain at each frequency in the active region of the ZnO-based THz-QCL using the design method of the present embodiment, and FIGS. 3A-E are each for a different design frequency. The ZnO-based THz-QCL designed in this scheme can cover the frequency range from 2 THz to 12 THz, and FIGS. 3A to 3E show typical examples of the design frequencies in the range of 3.5 to 10.5 THz. In FIG. 3A, the frequency range (5.4 THz to 14 THz) in which oscillation cannot be obtained due to the reststrahlen band in GaAs-based THz-QCLs is specified by double-headed arrows.

The gain characteristics shown in FIGS. 3A-E were calculated as follows. First, the conditions shown in Table 2 were determined so that the frequency shown in each figure (3. 5 THz for FIG. 3A, the same for the following) would provide the peak optical gain for the designed ZnO-based THz-QCL at room temperature (300 K). The frequency is called the design frequency because it is a frequency that is determined in advance as a target. In determining each design frequency, the numerical simulation based on the non-equilibrium Green's function (NEGF) method is used to determine the conditions (layer thickness of each layer, barrier height, or composition, and bias voltage). Therefore, the structure of the semiconductor superlattice structure 100A differs between FIGS. 3A to 3E, but is fixed within each figure. Then, the optical gain of the active region 10 was calculated by changing the frequency using numerical simulation again with the specific conditions determined.

The ZnO-based THz-QCL designed in the present embodiment is advantageous for use in high-temperature operation. In other words, as shown in FIGS. 3A-E, at frequencies from 3 THz to 12 THz, peak gain is maintained that overcomes the loss of the resonator (e.g., 20 /cm) not only at low temperatures (10 K) but also at room temperature (300 K). In particular, at the low frequency of 3.5 THz, it shows extremely high temperature tolerance, and the optical gains at 300 K decrease only slightly from 110 /cm to 80 /cm compared to 10 K. This is a result that reflects the LO phonon energy of ZnO-based semiconductor materials. Thus, it has been shown that the significant decrease in optical gain due to temperature rise, which was a problem with GaAs-based THz-QCLs, can be overcome with ZnO-based THz-QCLs.

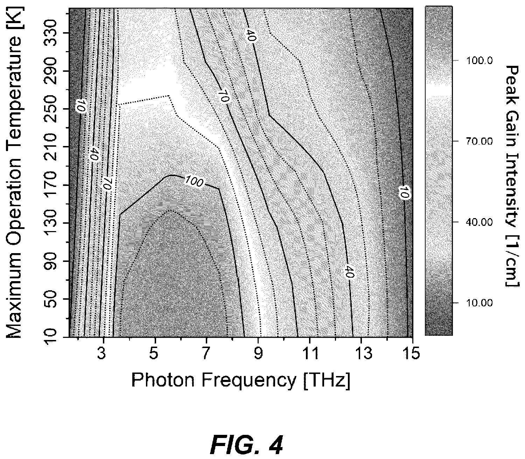

FIG. 4 is a map showing the peak intensity of the optical gain by density at each position as a function of the lasing frequency and the corresponding operating temperature in the ZnO-based THz-QCL of the present embodiment. FIG. 4 was calculated as follows. Optical gains are calculated for the ZnO-based THz-QCL, which is configured based on the design of the present embodiment, by changing the temperature for each frequency shown on the horizontal axis as the design frequency. FIG. 4 provides information on how easy it is to achieve lasing for each combination of design frequency and operating temperature.

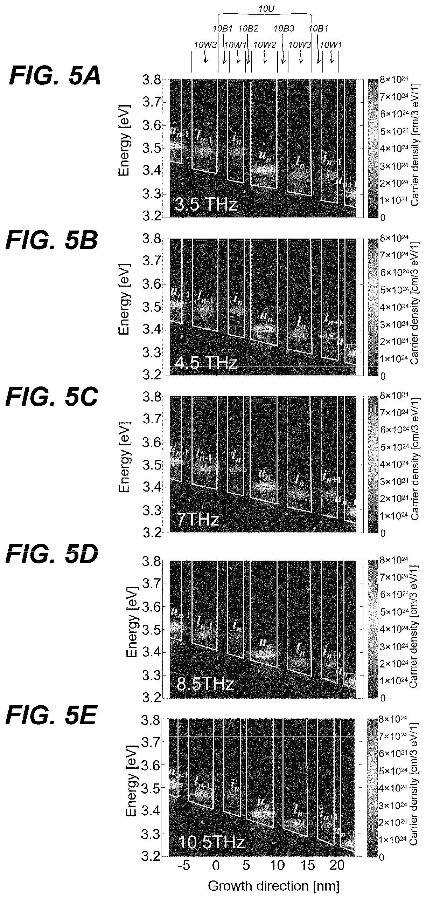

FIGS. 5A-E are maps showing the electron density distribution at room temperature (300 K) for different frequencies in the present embodiment, with respect to the position over the thickness direction and energy. In FIGS. 5A-E, the most electrons are present in the upper lasing level uₙ, and almost no electrons are present in the lower lasing level lₙ. In other words, it was confirmed that the population inversion is maintained over a wide range of frequencies at room temperature due to the combined effects of indirect injection by LO phonon scattering and electron depopulation by electron-electron scattering. At each frequency, the electron population of the upper lasing level uₙ was 35% of the entire population.

### 1-6. Designing Parameter Optimization Method (Design Strategy)

The structure of the ZnO-based THz-QCL in the present embodiment can be optimized for the desired lasing frequency and operating temperature by adjusting the details of each part, including the conditions shown in Table 2, etc. The structure can be optimized by making the conditions such that the population inversion is easily maintained without causing an increase in the linewidth of the optical transition. This is because if it is easier to maintain population inversion, the possibility of lasing at high temperatures increases. More specifically, in order to make the process of depopulating electrons from the lower lasing level lₙ to the injection level iₙ₊₁ using electron-electron scattering as fast as possible, it is useful to adjust the detuning energy and anti-crossing energy between the lower lasing level lₙ and the injection level iₙ₊₁. The lower lasing level lₙ and the injection level iₙ₊₁ are localized in the region between the first barrier layer 10B1, i.e., the region where electron scattering occurs.

The detuning energy described here is the difference between the energy values of the lower lasing level lₙ and the injection level iₙ₊₁. In a design example of the present embodiment, the detuning energy under the condition where a bias electric field is applied for lasing operation becomes an issue. In general, levels with small detuning energies form a coupling, and this coupling is maximized when the detuning energy becomes zero. Tunneling occurs between two levels only when the two levels have sufficiently close energy values resulting in a small detuning energy. To adjust the detuning energy, it is sufficient to adjust the relative energy values of the two levels, and generally, it is effective to adjust the potential by applying an external voltage or to adjust the thickness of the well layer, which affects the energy value of each level.

In addition, the anti-crossing energy described here is a parameter representing the degree of coupling between the lower lasing level lₙ and the injection level iₙ₊₁, and is defined as 2*h-bar*Ω in the Hamiltonian describing the system for theoretical analysis, where h-bar*Ω is the coefficient of an interaction term relating the transition of electrons and the generation of LO phonons, and h-bar = h/2π and h is Planck's constant. When two levels are spatially close enough to be coupled to each other and their energy values are close, even if the detuning energy value between them is not zero, the two levels couple to each other. As a result, electrons in the level with higher energy can be transported to the level with lower energy by electron-electron scattering. In the electron transport process of the THz-QCL in the present embodiment, this electron-electron scattering is intentionally utilized. We have found that the degree of coupling between the two levels, i.e., the anti-crossing energy 2*h-bar*Ω, is a very important parameter, along with the detuning energy ΔE. This anti-crossing energy 2*h-bar*Ω is calculated according to the designed layer structure and operating conditions when simulating the behavior of electrons based on the NEGF method. Specifically, it can be calculated from the wave functions of each of the Wannier-Stark mode and tight-binding mode.

The control of the detuning energy and the anti-crossing energy between the lower lasing level lₙ and the injection level iₙ₊₁ is explained in the case where the external electric field (bias electric field) is unchanged. The applied bias is basically determined by the target lasing frequency. When the thickness of the barrier layer (first barrier layer 10B1, FIG. 2D) where electron-electron scattering occurs between the lower lasing level lₙ and the injection level iₙ₊₁ is fixed to a value (e.g. 3 nm) at which coupling can occur between these levels, the coupling strength depends on the detuning energy. The smaller the detuning energy between the lower lasing level lₙ and the injection level iₙ₊₁, the stronger the coupling between the two levels, and the coupling is at its maximum when the detuning energy is zero. In this case, the two levels are perfectly aligned. For example, the detuning energy value would be ΔE =0 meV, and the anti-crossing energy value 2*h-bar*Ω would be 12 meV. In this case, the relationship between the lower lasing level lₙ and the depopulation level dₙ is shown in FIG. 2B, and the lower lasing level lₙ and the injection level iₙ₊₁ induce resonant tunneling. As mentioned in Section 1-3, the conditions causing resonant tunneling will increase the line width, making it difficult to operate THz-QCLs in ZnO-based semiconductors. However, if the detuning energy between the lower lasing level, lₙ, and the injection level, iₙ₊₁, is set to a non-zero value and the anti-crossing energy is also properly adjusted, then there occurs efficient electron-electron scattering resulting in suppression of line broadening. In other words, the adjustment here is to balance (1) ensuring that the detuning energy is not too small, as it may induce resonant tunneling, and (2) ensuring that the anti-crossing energy is not too high, as it may induce resonant tunneling, while also ensuring that the anti-crossing energy is not too small, as it may slow down electron transport due to electron-electron scattering. The requirement that the anti-crossing energy in (2) is not too high is automatically satisfied by (1). Therefore, the gain is expressed as a function of the detuned energy and anti-crossing energy, and a high gain is obtained by balancing these two energies.

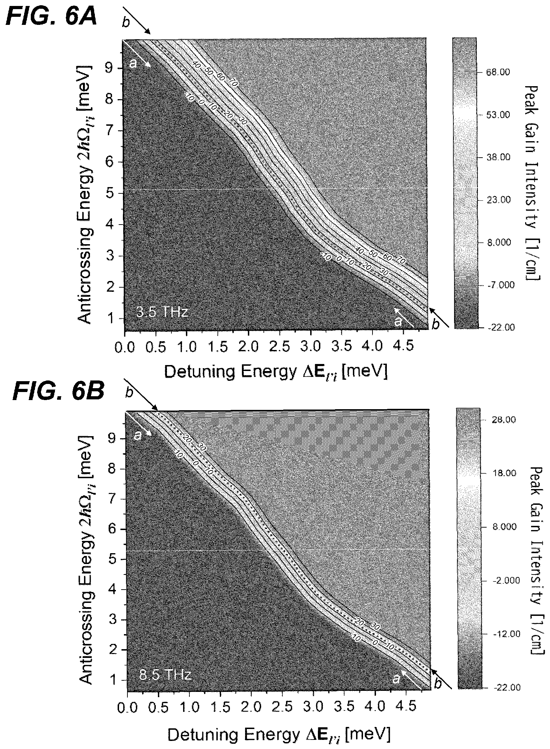

This balance can be understood more deeply if you consider the degree of gain that can be achieved for the combination of detuned energy and anti-crossing energy. FIGS. 6A-B are maps showing the variation in peak gain as a function of detuned energy and anti-crossing energy between the lower lasing level lₙ and the injection level iₙ₊₁ at lasing frequencies of 3.5 THz and 8.5 THz in the present embodiment of a ZnO-based THz-QCL. The values of the peak gain are important in the range from 0 to around 50 /cm, so only the contour lines with values in that range are shown with numerical values. The lower lasing level lₙ and the injection level iₙ₊₁ are shown in FIGS. 2C and 2D. The detuning energy and the anti-crossing energy both play roles in determining the depopulation efficiency without excessively increasing the linewidth at the lower lasing level, lₙ. In each graph, the cavity loss, which serves as a guide for the lasing threshold, is about 20 /cm, and the dotted line indicates the conditions for obtaining 15/cm.

It is important in the design of the present embodiment to achieve a balance between the detuning energy and the anti-crossing energy. The combinations of detuning energy and anti-crossing energy that result in a certain peak gain value are shown as contour lines in the parameter space shown in FIGS. 6A and 6B. In other words, each of these contour lines traces a curve that deviates gradually from the downward-sloping straight line. In each figure, straight lines corresponding to the positions indicated by the pair of arrows 'a' that point to each other satisfy the relationship ΔE + h-bar*Ω = 5.0 meV, and straight lines corresponding to the pair of arrows 'b' satisfy the relationship ΔE + h-bar*Ω = 5.5 meV, respectively. Here, ΔE is the detuning energy, and h-bar*Ω is half of the anti-crossing energy. In the maps for each figure, if you trace one of these straight lines, the peak gain value will change gradually in accordance with the above gradual deviation. In contrast, if you trace a line that is perpendicular to these straight lines, the peak gain will change drastically. Therefore, the balance between the detuning energy and the anti-crossing energy can be approximately determined by evaluating the sum of the detuning energy and half of the anti-crossing energy, that is, excluding the deviation from the above-mentioned downward-sloping line. With a balance constrained to the line aligned with the position indicated by the pair of arrows a, the peak gain reaches a maximum value of around 20 /cm. In other words, when ΔE + h-bar * Ω = 5.0 mV is satisfied, the possibility of lasing operation begins to arise. Satisfying ΔE + h-bar * Ω ≥ 5.0 mV is a necessary condition for performing lasing operation. On the other hand, in the case of balanced confinement to a straight line aligned with the position indicated by the pair of arrows 'b', the minimum peak gain is around 20 /cm. In other words, when ΔE + h-bar * Ω = 5.5 meV is satisfied, the possibility of lasing operation begins to arise. Satisfying ΔE + h-bar * Ω ≥ 5.5 meV is a sufficient condition for lasing operation to be achieved.

In the case of balancing mentioned above, the numerical range of the detuned energy ΔE that is preferable for achieving a high optical gain may be further limited. The gradual deviation mentioned above is expressed as a deviation from the downward-sloping line in a part of the entire range of the detuned energy, not the entire range. Since a good optical gain is achieved, the range where the deviation appears indicates a preferable condition. In other words, good optical gain can be achieved in the range where the lower limit of the detuned energy ΔE is 2.0 meV or more, and it is even more favorable in the range where it is 2.5 meV or more, and it is most favorable when it is 3.0 meV or more. In addition, good optical gain can be performed in the range where the upper limit of the detuned energy ΔE is 4.5 meV or less, and it is even more preferable in the range of 4.0 meV or less, and it is most preferable when it is 3.5 meV or less. The numerical values that define these lower and upper limits can be used in any combination.

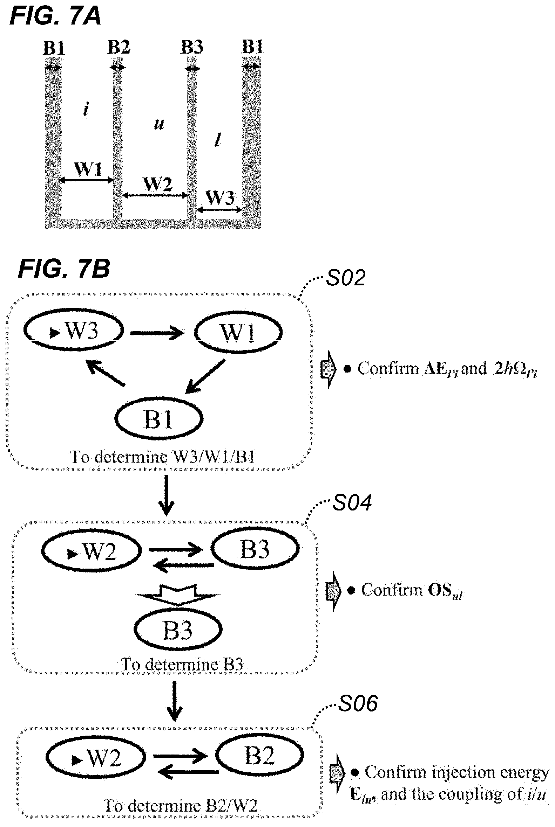

The optimization of the specific structure of the quantum wells and quantum barriers of the ZnO-based THz-QCL to be designed in the present embodiment can be carried out based on the following design strategy. FIGS. 7A and 7B are schematic diagrams and flowcharts to explain the design strategy in the present embodiment. FIG. 7A is a schematic diagram of the structure of the semiconductor superlattice structure 100A. Here, the thicknesses of the first barrier layer 10B1 to the third barrier layer 10B3 are denoted as B1 to B3, and the thicknesses of the first well layer 10W1 to the third well layer 10W3 are denoted as W1 to W3.

The design optimization of ZnO-based THz-QCL in the present embodiment is performed under appropriate constraint conditions. The constraint conditions include, in addition to the target lasing frequency, constraints imposed on, for example, the external electric field, well depth, and dipole matrix elements. In other words, the external electric field is related to the thickness of the QCL structure 100, i.e. the period and total number of layers of the unit structure 10U, and the voltage applied between the conductive portion (TCO layer) 20 and the conductive portion 30, and is set according to the lasing frequency, for example, from a range of 10 kV/cm to 100 kV/cm. The well depth is determined by the barrier height, or the compositions of the well layer and barrier layer. In the general formula, the well is of the composition Zn₁₋ₓMgₓO and the barrier is of the composition Zn_{1-y}Mg_{y}O, for 0≤x<y≤1. Here, as the value of y-x increases, the well depth (barrier height) increases, and for example, a value of 0.15 is employed. Since the external electric field and well depth (barrier height) are often allowed only a very narrow adjustment range as parameters based on the lasing frequency and other operating conditions, we will explain the case where they are fixed. In addition, the dipole matrix element for the radiation that governs the optical transition probability is related to the emission intensity, but we will explain it by fixing it to a suitable value, such as 1 nm.

Optimization under these constraint conditions is performed first by setting the thickness W3 of the third well layer 10W3, and then setting the thickness W1 of the first well layer 10W1 and the thickness B1 of the first barrier layer 10B1 (step S02). Once the thicknesses W3, W1 and B1 have been set, the lower lasing level lₙ and the injection level iₙ₊₁ can be determined, and the detuning energy ΔE and anti-crossing energy 2*h-bar*Ω between the levels can be calculated. In step S02, the thicknesses W3, W1, and B1 are optimized until the detuning energy ΔE and anti-crossing energy 2*h-bar*Ω reach the desired values. At this step, not all the layer designs are determined, but this optimization is possible. This is because from FIGS. 6A and 6B, it is possible to determine whether the conditions are favorable for increasing the peak gain from the detuned energy ΔE and the anti-crossing energy 2*h-bar*Ω. Making the detuning energy value in (1) above not too small is typically done by making the lower lasing level lₙ have a higher energy than the injection level iₙ₊₁, so that the detuning energy is greater than zero. In general, when the wells are made thicker, the energy measured from the bottom of the wells at the internal levels decreases. In addition, according to allocation of probability amplitudes of the levels in FIG. 2D, when the third well layer 10W3 and the first well layer 10W1 are thickened, the injection level iₙ₊₁ is strongly affected by the thickness W3 of the third well layer 10W3, and the lower lasing level lₙ is strongly affected by the thickness W1 of the first well layer 10W1. By utilizing this relationship, the detuning energy ΔE can be adjusted. As a result, for example, the thickness W1 of the first well layer 10W1 is made smaller than the thickness W3 of the third well layer 10W3. If the thicknesses W1 and W3 are the same, or if the thickness W1 is larger, it is difficult to adjust the detuning energy ΔE and the anti-crossing energy 2*h-bar*Ω between the lower lasing level lₙ and the injection level iₙ₊₁ to appropriate values due to the slope of the potential caused by the external electric field. Making the thickness W1 of the first well layer 10W1 smaller than the thickness W3 of the third well layer 10W3 is preferable for adjusting the detuning energy ΔE and anti-crossing energy 2*h-bar*Ω. In addition, to make the anti-crossing energy in (2) not too small, the structure of the first barrier layer 10B1 is adjusted. Even when the well depth is fixed, it is useful to adjust the thickness of the first barrier layer 10B1. Specifically, by reducing the thickness B1 of the first barrier layer 10B1, the coupling between the lower lasing level lₙ and the injection level iₙ₊₁ can be enhanced. By reducing the thickness B1 as necessary, this coupling can be sufficiently enhanced. The resulting optimal values for the thicknesses W3, W1, and B1 are fixed.

Next, in Step S04, the thickness W2 of the second well layer 10W2 is set, and the thickness B3 of the third barrier layer 10B3 is set. This allows the oscillator strength OSᵤₗ to be determined using the set dipole matrix elements. Since the oscillator strength is a guide for optical gain, the thicknesses W2 and B3 that maximize this value are searched for and fixed as the optimal values.

Finally, as step S06, the thickness W2 of the second well layer 10W2 and the thickness B2 of the second barrier layer 10 (injection barrier layer) are optimized again. This optimization is performed so that electron transport by diagonal transition due to electron-LO phonon scattering is achieved between the injection level iₙ and the upper lasing level uₙ. The thicknesses W2 and B2 are fixed in this way. This allows the energy difference (injection energy) Eᵢᵤ between the injection level iₙ and the upper lasing level uₙ, as well as the coupling energy, to be determined, and this in turn provides a guide for the electron transport of the diagonal transition.

### 1-7. Comparison of Depopulation Methods

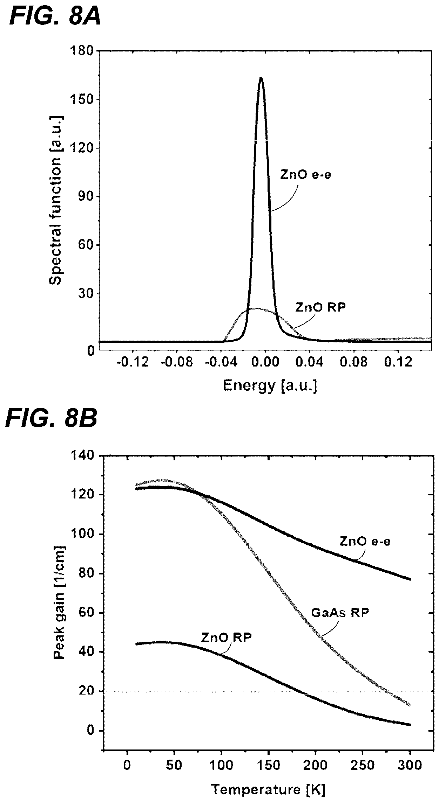

In the present embodiment, electron-electron scattering is employed in the design of the ZnO-based THz-QCL, whereas in the design examples based on conventional ideas, depopulation of electron from the lower lasing level for population inversion is attributable to RP (resonant phonon scattering). FIG. 8A shows the calculated emission spectrum of a ZnO-based THz-QCL designed to operate at 8 THz, which was designed based on the present embodiment and conventional ideas.

Each performance is based on the assumption that the structure of the ZnO-based THz-QCL designed using the method of the present embodiment has a design frequency of 7 THz, as shown in FIGS. 3C and 5C, and that the structure of the design based on the conventional concept uses RP, as shown in FIGS. 2A and 2B. FIG. 8A clearly shows the width of the quantum levels in the design based on the conventional idea of using RP and the design in the present embodiment that uses electron-electron scattering. In FIG. 8A, the scales are identical so that a comparison can be made between the present embodiment and the conventional method that uses resonant phonons. The calculation results suggest that even if the design that uses resonant phonons, which is the most commonly used in GaAs-based THz-QCLs, is applied directly to ZnO-based semiconductors, the lower lasing level l itself will be directly affected by the LO phonons, which have a large energy. This is a consequence of the fact that the depopulation of electrons from the lower lasing level l in ZnO-based semiconductors is carried out by LO phonons. As a result, the energy of the upper lasing level u, which is responsible for the optical transition, and the lower lasing level l have an excessively broad linewidth, and sufficient gain cannot be obtained. In fact, the increased linewidth in the design using resonant phonons, as shown in FIG. 8A, corresponds to a very small optical gain of about 0.5 /cm at 300 K. In contrast, in the design example of the present embodiment using electron-electron scattering, the increase in linewidth can be sufficiently suppressed even at the same 300 K.

### 1-8. Temperature Characteristics

FIG. 8B shows the calculated peak gain values at each temperature for a ZnO-based THz-QCL designed to operate at 8 THz and a GaAs-based THz-QCL designed to operate at 4 THz, based on the present embodiment and the conventional approach, respectively (FIG. 8B). The peak gain values for the three designs shown in FIG. 8B are optical gain values for the semiconductor superlattice layers under the same doping level conditions for fair comparison, and the temperature dependence of these values is shown in FIG. 8B. The dotted line in the figure also shows the line for cavity loss of about 20 /cm, which gives a criterion for lasing operation. The ZnO-based THz-QCL designed according to the present embodiment is labeled "ZnO e-e"; the designs based on the conventional concept that utilize the depopulation due to resonance phonon are labeled "ZnO RP" for ZnO-based THz-QCL and "GaAs RP" for GaAs-based THz-QCL at 4 THz -QCL. In the method that uses the resonance phonon for depopulation often adopted in GaAs-based THz-QCLs, as shown in the "GaAs RP" line, high gain is achieved at low temperatures, but the gain rapidly decreases as the temperature approaches room temperature (300 K). Even if the depopulation mechanism by way of resonance phonon used in GaAs-based THz-QCLs is applied as-is to a ZnO-based THz-QCL operating at 8 THz to realize a structure like that shown in FIG. 2B, the gain will decrease and the ceiling of operating temperature for lasing will also decrease, as shown in the "ZnO RP" line. This is because conventional concepts themselves are unable to adequately deal with the strong Fröhlich coupling in ZnO-based semiconductors. In contrast, in the present embodiment, which uses electron-electron scattering, high gain is achieved at each temperature, as in the "ZnO e-e" line, and in particular, the decrease in gain at high temperatures is significantly suppressed. As such, in the design example using the method of the present embodiment, the resistance of gain to temperature is clearly shown.

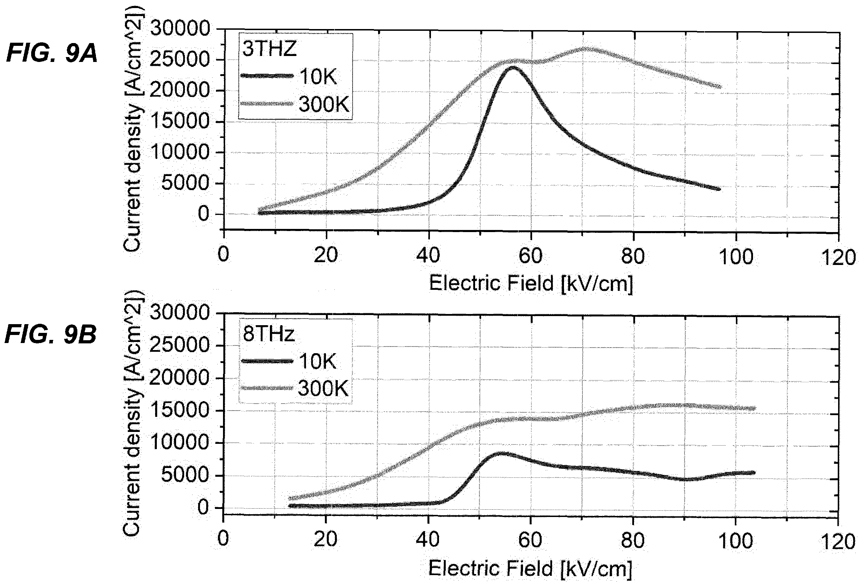

FIGS. 9A and 9B are graphs showing the dependence of current density on electric field for ZnO-based THz-QCL in the present embodiment. The calculations were performed for a single period of the unit structure. FIGS. 9A and 9B are for lasing frequency design values of 3 THz and 8 THz, respectively. When the lasing frequency is designed to be low at 3 THz, the parasitic current around 56 kV/cm becomes significantly large due to the resonance tunneling process. Therefore, the dynamic range at 300 K is relatively small in the ZnO-based THz-QCL designed to lasing at 3 THz. The dynamic range here is defined as the current range between the current at which the maximum gain is achieved and the current at which the gain is exactly equal to the loss of the resonator (threshold current for lasing). In other words, the dynamic range of a ZnO-based THz-QCL lasing at 3 THz is estimated to be 1300 A/cm². On the other hand, the dynamic range of a ZnO-based THz-QCL with a lasing frequency design value of 8 THz is very large at 300 K, being approximately 2600 A/cm². From these comparisons, it can be concluded that in the present embodiment, it is easier to make the ZnO-based THz-QCL lasing at high frequencies than at low frequencies.

### 2. Variations

Various variations are provided in the present embodiment.

### 2-1. Materials

In the above description of the embodiment of the present disclosure, the same material (e.g., ZnO) has been used for each well layer and the same material (Zn_{0.8}Mg_{0.2}O) has been used for each barrier layer. However, in the design of the present disclosure, it is also permissible to use a different material for each well layer or a different material for each barrier layer. To control the electron transport process by forming quantum wells and quantum barriers using the potential that acts on electrons through the conduction band edge profile, changing the material to appropriately adjust the energy values of each level can be an effective method for optimizing the ZnO-based THz-QCL, which is implemented by designing the embodiment of the present disclosure. In addition, in the selection of preferred materials, ZnO is used for each well layer and Zn_{1-y}Mg_{y}O (where 0.1≤y≤0.2) is used for each barrier layer. The MgO composition ratio y in the mixed crystal of ZnO and MgO is a parameter for directly controlling the well depth (barrier height).

### 2-2. Polar ZnO/ZnMgO Quantum Well System

The above description of the embodiment of the present disclosure assumes a potential profile that is performed in a quantum well using a ZnO-based semiconductor grown in a non-polar orientation. ZnO-based semiconductors can also be grown in a polar orientation, and in that case, the Fröhlich coupling is still stronger than in GaAs-based materials. This is because, although the conditions for epitaxial growth and the quality of the grown crystals generally differ depending on whether there is a polarity or not, there is no significant change in the dielectric properties or the resulting effective mass of the electrons (Table 1). For this reason, the above explanation of the present embodiment also applies to ZnO-based semiconductors with a growth direction in the polar orientation. In particular, the design concept of each level and the knowledge of the electron transport mechanism that forms the basis of the design concept also apply to ZnO-based semiconductors grown in the polar direction.

### 2-3. Frequency Range for Laser Operation

The lasing operation of ZnO-based THz-QCLs in the embodiments of the present disclosure was explained based on examples of low-frequency lasing in the range of 3 to 3.5 THz and high-frequency lasing in the range of 8 to 8.5 THz. Such operation is possible over the entire frequency range of 2 THz to 13 THz. In particular, the operating temperature range includes high temperature regions, including room temperature (300 K), although it depends not only on the frequency but also on the resonator performance at the lasing frequency. In particular, the frequency range of 6 THz to 12 THz is a THz gap that cannot be achieved with GaAs-based semiconductor materials, and the present embodiment of a THz-QCL element that can operate in this frequency range by utilizing the characteristics of ZnO-based semiconductor materials is advantageous.

### 3. Conclusion

The embodiments of the present disclosure have been described in detail in the above. The above embodiments, variations and examples are provided to explain the invention disclosed in this application, and the scope of the invention of this application should be determined based on the claims. Variations that exist within the scope of the present disclosure, including other combinations of embodiments, are also included in the claims.

### Reference Signs List

1000 QCL element
100 QCL structure (100a semiconductor superlattice structure)
10 active layer
10B, 10B1-10B4 barrier layer
10W, 10W1-10W3 well layer
10u unit structure
20 conductive portion (TCO layer)
22, 32 metal contact
24 passivation film
30 conductive portion
40 receptor substrate
50 substrate
60 etching stopper layer
120, 140 highly doped layer
160 δ-doped layer
2000 electromagnetic wave

## Claims

1. A quantum cascade laser element having a semiconductor superlattice structure sandwiched between a pair of conductive portions,
wherein the semiconductor superlattice structure has a plurality of unit structures that are repeatedly stacked,
wherein each unit structure consists of:
three well layers each having a composition of ZnO or ZnMgO; and
barrier layers each having a composition of ZnMgO or MgO, the barrier layers separating the well layers from one another and having a higher content of MgO than the well layers adjacent thereto on both sides, and
wherein the semiconductor superlattice structure serves as an active region for emitting electromagnetic waves of a wavelength upon application of an external voltage through the pair of conductive portions for operation.

2. The quantum cascade laser element according to claim 1, wherein
the compositions for all of the three well layers are Zn₁₋ₓMgₓO, and
the compositions for all of the barrier layers are Zn_{1-y}Mg_{y}O,
where 0≤x<y≤1.

3. The quantum cascade laser element according to claim 2, wherein
the compositions for all of the three well layers are ZnO, and
the compositions for all of the barrier layers are Zn_{1-y}Mg_{y}O,
where 0.1≤y≤0.2.

4. The quantum cascade laser element according to claim 1,
wherein the three well layers include a first well layer, a second well layer, and a third well layer in this order from upstream to downstream of a flow of electrons,
wherein the unit structure under the external voltage is configured such that:
an injection level is formed with its maximum amplitude in the first well layer,
an upper lasing level is formed with its maximum amplitude in the second well layer, and
a lower lasing level is formed with the maximum amplitude in the third well layer, and
wherein, under the external voltage,
electrons at the upper lasing level in a unit structure make optical transitions to the lower lasing level in the unit structure, and
electrons at the lower lasing level in the unit structure are depopulated to an injection level in another unit structure adjacent to the unit structure on the downstream side due to electron-electron scattering.

5. The quantum cascade laser element according to claim 4, wherein, under the external voltage, electrons at the injection level in a unit structure are injected into the upper lasing level in the unit structure due to electron-LO phonon scattering.

6. The quantum cascade laser element according to claim 4, wherein
a detuning energy value between an injection level of a unit structure and a lower lasing level of another unit structure adjacent to the unit structure on the upstream side is greater than zero, and
an anti-crossing energy value between the injection level and the lower lasing level is greater than zero.

7. The quantum cascade laser element according to claim 6, wherein sum of the detuning energy value and half of the anti-crossing energy value is 5 meV or more.

8. The quantum cascade laser element according to claim 6, wherein the sum of the detuning energy value and half of the anti-crossing energy value is 5.5 meV or more.

9. The quantum cascade laser element according to claim 4, wherein, under the external voltage,
the injection level is a ground state for the first well layer,
the upper lasing level is a ground state for the second well layer, and
the lower lasing level is a ground state for the third well layer.

10. The quantum cascade laser element according to claim 1, wherein the electromagnetic wave is an electromagnetic wave of a frequency between 6 THz and 12 THz, both inclusive.
